# FASCICULE DE BREVET EUROPEEN

(11) **EP 1 638 796 B1**
(45) Date de publication et mention de la délivrance du brevet: **12.11.2008**
(21) Numéro de dépôt: 04767530.1
(22) Date de dépôt: 30.06.2004
(51) Int. Cl.: B60J 7/20, B60J 5/10

(54) **CAPOT DE COFFRE ARRIERE A ARTICULATION DOUBLEMENT VERROUILLEE POUR UN VEHICULE DECOUVRABLE A TOIT REPLIABLE**
KOFFERRAUMHAUBE MIT DOPPELVERRIEGELUNGSGELENK FÜR EINEN CABRIO MIT KLAPPVERDECK
REAR DECK HOOD WITH DOUBLE-LOCK ARTICULATION FOR CONVERTIBLE VEHICLE WITH FOLDING ROOF

(30) Priorité: 02.07.2003 FR 0308052
(43) Date de publication de la demande: 29.03.2006
(73) Titulaire: Société Européenne de Brevets Automobiles, 75011 Paris (FR)
(72) Inventeur: QUEVEAU, Gérard, F-79140 Le Pin (FR); QUEVEAU, Paul, F-79140 Montravers (FR); GUILLEZ, Jean-Marc, F-79140 Cirières (FR)
(74) Mandataire: Pichat, Thierry
(86) Numéro de dépôt international: PCT/FR2004/001687
(87) Numéro de publication internationale: WO 2005/012018

(56) Documents cités:
- EP-A- 1 084 886
- DE-A- 4 411 694
- US-B1- 6 250 707

## Description

La présente invention concerne le pivotement d'un capot de coffre arrière de véhicule découvrable à toit repliable à l'intérieur de ce coffre. Des groupes de pivotement avant et arrière sont prévus.

La présente invention se rapporte donc au dispositif défini à cet effet, appliqué sur le véhicule correspondant, à l'endroit de son coffre arrière.

On connaît, d'après FR-B-2 777 241, une solution où chaque groupe de pivotement est un verrou ayant pour fonction soit le verrouillage, soit l'articulation du capot de façon que celui-ci puisse s'ouvrir soit de l'avant vers l'arrière, soit de l'arrière vers l'avant.

On connaît également US-A-6250707 et EP-A-1084886.

La solution ici concernée s'applique sur un véhicule découvrable comprenant un coffre arrière, un capot pour ce coffre et un toit repliable à l'intérieur du coffre, un groupe de pivotement avant étant adapté à faire pivoter le capot de l'arrière vers l'avant et un groupe de pivotement arrière adapté à faire pivoter ce capot de l'avant vers l'arrière, chaque groupe de pivotement comprenant une assise liée fixement à la carrosserie du véhicule, un corps qui est lié au capot par un organe formant charnière et qui comprend un premier élément d'assemblage adapté à engager de manière amovible un second élément d'assemblage lié à l'assise correspondante, et des moyens de verrouillage et déverrouillage comprenant un premier moyen d'engagement lié à l'assise de façon mobile et adapté pour engager de manière libérable un second moyen complémentaire d'engagement lié au premier élément d'assemblage pour, dans une position verrouillée, verrouiller le corps par rapport à ladite assise. Le premier élément d'assemblage de chaque groupe de pivotement comprend un troisième moyen complémentaire d'engagement adapté pour être engagé de manière libérable par le premier moyen d'engagement, lequel est conçu pour pouvoir occuper plusieurs positions dont une position de rotation autorisée du capot dans laquelle, à l'endroit de l'un parmi les groupes de pivotement avant et arrière, ce premier moyen d'engagement maintient engagé avec lui le second moyen complémentaire d'engagement tout en libérant de son engagement le troisième moyen complémentaire d'engagement, assurant ainsi l'effet de charnière lors du pivotement d'ouverture du capot

Pour performante qu'elle soit, cette solution peut être améliorée pour obtenir un pivotement du capot encore plus précis, un mécanisme d'articulation encore plus performant et une possibilité de rattrapage du jeu entre le corps et l'assise concernée.

Tel est un but de la présente invention.

Pour cela, il est proposé qu'à l'endroit de l'autre parmi lesdits groupes de pivotement avant et arrière, le premier moyen d'engagement libère de leur engagement avec lui à la fois le second et le troisième moyens complémentaires d'engagement, pour que le capot puisse alors être écarté à cet endroit de la carrosserie en pivotant autour de ladite charnière créée, ce premier moyen d'engagement (16) rencontrant et appuyant successivement sur les deuxièmes puis troisième moyens complémentaires d'engagement lors de ce verrouillage du corps par rapport à l'assise.

On obtient ainsi un double verrouillage sélectif.

Pour favoriser en outre d'autant mieux le rattrapage du jeu évoqué entre le corps et l'assise concernée, on conseille par ailleurs:
- que l'organe formant charnière des(de chaque) groupe(s) de pivotement comprenne au moins un bras articulé d'un côté vis-à-vis du capot et à l'autre extrémité vis-à-vis d'une patte appartenant au corps,
- que chaque deuxième élément complémentaire d'engagement consiste dans une conformation d'appui solidaire de la patte concernée,
- que chaque troisième élément complémentaire d'engagement consiste dans une conformation d'appui solidaire dudit bras,
- et que le premier élément d'engagement correspondant rencontre et appuie successivement sur ces deuxième puis troisième éléments complémentaires d'engagement lors du verrouillage du corps par rapport à l'assise, le bras pourvu dudit troisième élément complémentaire d'engagement appuyant alors lui-même sur une partie de la patte dans le sens de l'engagement de l'élément d'assemblage concerné avec l'autre, lors du verrouillage.

Ainsi, on guide et entraîne positivement le corps et donc le capot jusqu'à la position verrouillée et on limite le jeu entre ce capot et l'assise (donc le châssis).

Une telle structure est bien adaptée pour tenir compte de tous les jeux et tolérances dus aussi bien aux conditions de montage du capot qu'aux déformations de celui-ci lors de ses différents mouvements de pivotement, tout en assurant son guidage positif jusqu'à sa position verrouillée, avec un double verrouillage, gage d'efficacité.

D'autres particularités et avantages de la présente invention, voire d'un verrouillage « à appui constant », apparaîtront dans la description détaillée ci-après qui se rapporte aux annexés, donnés à titre d'exemples non limitatifs, et dans lesquels :
- la figure 1 est une vue schématique partielle, en coupe longitudinale, d'un véhicule découvrable à toit repliable comportant un capot de coffre arrière selon l'art antérieur ;
- les figures 2a et 2b sont des vues agrandies avec arrachements des détails A et B à la figure 1, représentant respectivement un ensemble du groupe de pivotement avant et un ensemble du groupe de pivotement arrière d'un capot de coffre arrière suivant un mode de réalisation de la présente invention, ledit capot étant dans sa position fermée ;
- la figure 3 montre en vue agrandie une partie essentielle de l'ensemble du groupe de pivotement avant de la figure 2a;
- la figure 4 est une vue selon la coupe IV-IV de la figure 3, le crochet étant dans sa position verrouillée,
- et les figures 5 et 6 illustrent schématiquement deux alternatives de verrouillage.

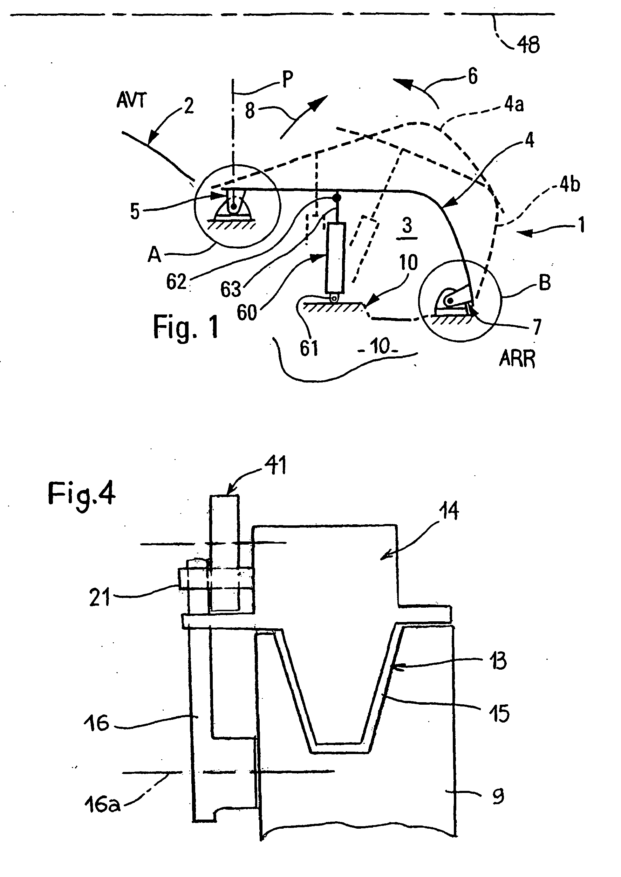

On a représenté schématiquement à la figure 1 un véhicule découvrable, référencé 1, dont le toit 2 est repliable à l'intérieur du coffre arrière 3 du véhicule
1. Un tel toit repliable 2 est connu.

Le capot 4 du coffre arrière 3 comprend, de préférence vers son bord avant (AVT), un groupe de pivotement avant 5 incluant deux ensembles identiques adaptés à faire pivoter ce capot de l'arrière vers l'avant, dans le sens de la flèche 6 à la figure 1, jusqu'à la position schématisée en 4a, pour un accès facile au coffre arrière, par exemple pour y déposer des bagages (non représentés).

Le capot 4 pivote de façon classique sous l'action d'au moins un vérin 60 (typiquement deux vérins 60 disposés de part et d'autre du coffre arrière 3). Chaque vérin est articulé à sa base 61 sur la carrosserie 10 du véhicule, et l'extrémité 62 de sa tige 63 est articulée sur le capot 4.

Le capot 4 comprend également, apriori vers son bord arrière (ARR), un groupe de pivotement arrière 7 avec deux ensembles adaptés à faire pivoter le capot 4 de l'avant vers l'arrière, dans le sens de la flèche 8, jusqu'à la position 4b, pour permettre le passage et le rangement du toit 2 replié à l'intérieur du coffre arrière 3.

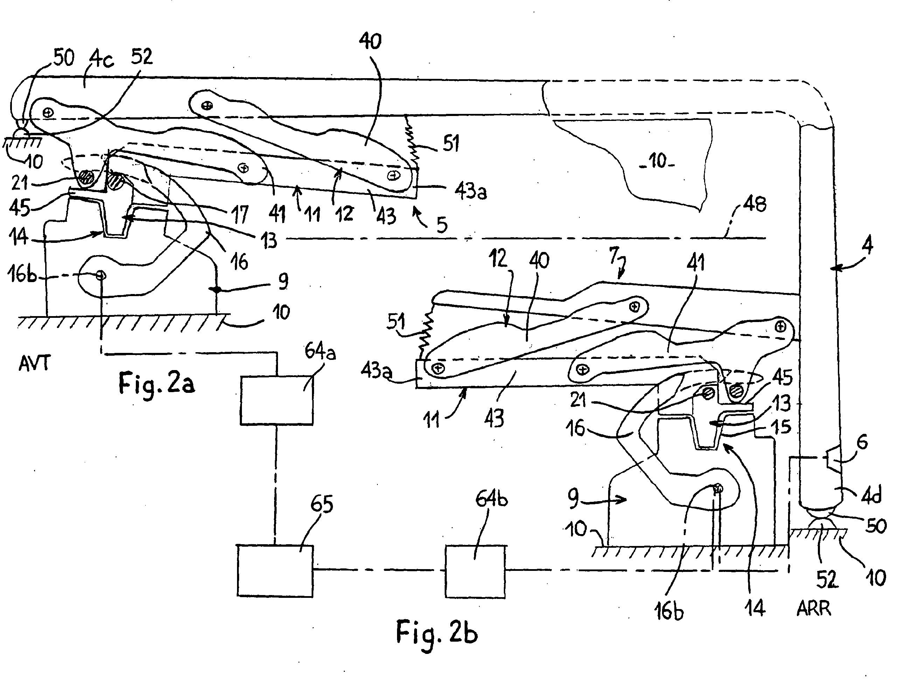

Comme représenté en détail aux figures 2a, 2b, chaque groupe ou ensemble de pivotement 5, 7 comprend une assise 9 fixée à la carrosserie 10 du véhicule et qui comprend un premier élément d'assemblage 13 adapté à engager de manière amovible un second élément d'assemblage 14 faisant partie d'un corps 11 relié au capot 4 par une structure formant charnière 12. De préférence les éléments 13,14 sont de forme complémentaires.

Comme représenté notamment aux figures 2a à 4, le premier élément d'assemblage 13 est un élément un élément mâle sensiblement en forme de coin adapté pour s'engager une cavité 15 sensiblement en forme de coin du second élément d'assemblage femelle 14. La surface 13a de l'élément saillant 13 guide la fin du pivotement du capot, en accompagnant l'élément le long des parois 15b de la cavité 15.

La forme de coin des premier et second éléments d'assemblage assure un guidage précis de la fin du mouvement de pivotement du capot 4 vers sa position fermée verrouillée, ces formes de coin s'entendant selon un plan vertical P transversal par rapport au capot.

Chaque groupe de pivotement 5, 7 comporte également des moyens de verrouillage/déverrouillage comprenant un premier moyen d'engagement 16 lié de façon mobile à l'assise 9 correspondante et adapté pour engager de manière libérable un second moyen complémentaire d'engagement 17 lié au premier élément d'assemblage 13 pour, dans une position verrouillée, verrouiller le corps 11 par rapport à l'assise 9 correspondante.

De préférence, les moyens de verrouillage comprennent chacun, en tant que premier moyen d'engagement 16, un crochet monté de manière pivotante sur l'assise 9 (axe 16b) et adapté à venir en prise avec le second moyen complémentaire d'engagement 17, lequel définit avantageusement une conformation d'appui en forme d'ergot: Le crochet prend appui sur cette conformation et guide la fin du mouvement de pivotement du capot jusqu'à la position verrouillée correspondante.

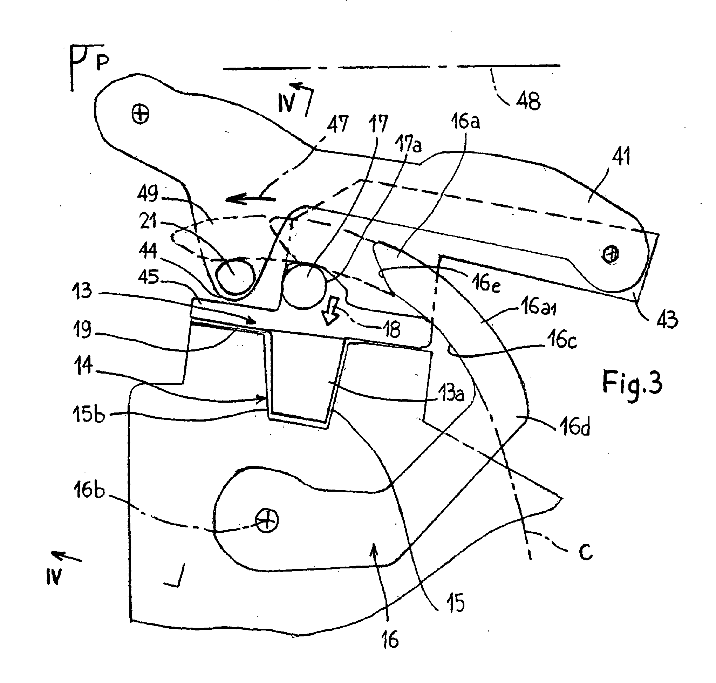

Dans ce mode de réalisation, l'extrémité libre 16a du crochet 16 est biaisée et la surface supérieure d'appui de l'ergot 17 est arrondie, ce qui favorise l'effet d'appui et la limitation du jeu à l'endroit du plan de joint 19 entre les parties 13 et 14 (figure 3).

A la fois pour favoriser ce rattrapage de jeu et pour obtenir l'effet de double verrouillage déjà évoqué, le premier élément d'assemblage 13 de chaque groupe de pivotement avant et arrière comprend en outre, conformément à l'invention, un troisième élément complémentaire d'engagement 21 adapté pour être engagé de manière libérable par le moyen 16, de telle sorte que :
- pour un verrouillage en position fermée du capot, les premiers éléments mobiles d'engagement 16 des groupes de pivotement avant et arrière engagent de façon coordonnée les seconds (17) et troisièmes (21) éléments complémentaires d'engagement correspondants,
- tandis que, pour une ouverture pivotée vers l'arrière du capot 4, lors d'un repliement ou d'un déploiement du toit 2 dans le (ou hors du) coffre, chaque premier élément 16 d'engagement des groupes de pivotement arrière et avant agit pour respectivement engager uniquement le second élément complémentaire d'engagement 17 correspondant du groupe de pivotement arrière 7 et libérer de façon coordonnée les seconds et troisièmes éléments complémentaires d'engagement du groupe de pivotement avant 5; et inversement pour une ouverture pivotée vers l'avant du capot.

Dans la solution illustrée, on obtient ainsi, en fonction de l'angle d'engagement (rotation) des crochets 16, un verrouillage complet du capot 4 ou une ouverture autorisée de celui-ci, vers l'avant ou l'arrière.

De préférence, chaque troisième élément complémentaire d'engagement 21 consiste, comme l'élément 17, dans une conformation d'appui. Et celle-ci est avantageusement disposée de manière que le crochet 16 correspondant rencontre et appuie successivement, lors de la fermeture verrouillée du capot, sur le deuxième puis le troisième élément complémentaire d'engagement concerné.

A cet égard, on notera que, dans la solution illustrée, tant les conformations 17 que 21 se présentent chacune comme un ergot faisant saillie vers le crochet 16, transversalement à la direction d'engagement 18, et le crochet 16 est conformé et disposé sur l'assise 9 de manière que son extrémité libre 16a appuie sur les ergots lorsqu'elle les rencontre, pour doublement d'une part solliciter le premier élément d'assemblage 13 dans le sens de la flèche 18 vers sa position verrouillée dans l'assise 9 correspondante, et d'autre part l'y verrouiller.

A l'image de la surface supérieure d'appui des ergots 17, celle des ergots 21 est d'ailleurs ici arrondie, pour les mêmes raisons.

En outre, le crochet 16 est avantageusement conformé de manière à s'opposer à toute tentative d'ouverture du capot 4, dans la mesure où un effort dirigé verticalement vers le haut s'exerçant sur le premier élément d'assemblage 13 n'exerce sur le crochet aucune force tendant à le faire pivoter vers sa position déverrouillée (trait plein sur les figures 2a, 2b, la position verrouillée de l'extrémité du crochet étant représentée en pointillés).

De la même manière, le (chaque) crochet 16 est conformé et agencé sur l'assise 9, par rapport aux éléments 17, 21, de façon telle qu'il est adapté à venir en prise avec eux dans une position de l'élément 13 aussi distante que possible de sa position verrouillée. Le premier moyen d'engagement 16 est ainsi un élément moteur commandant la fin du mouvement de pivotement du capot 4, en coopération avec les vérins 60.

Le capot 4 comporte des moyens 64a, 64b (figure 2a, 2b) pour faire pivoter chaque crochet 16 dans un sens ou dans l'autre autour de son axe de pivotement (ici horizontal 16b) pour verrouiller ou libérer le premier élément d'assemblage 13. Ces moyens de pivotement peuvent être des moyens connus quelconques, et peuvent comprendre un moteur entraînant, par exemple, une vis sans fin engrenant avec une denture solidaire du crochet. Une unité embarquée de contrôle 65 à microprocesseur et/ou capteurs commande les moteurs de façon appropriée, en particulier pour coordonner les mouvements des moyens 16 lors du verrouillage ou d'une ouverture du capot. A noter que le véhicule comporte en outre de préférence des moyens, tel qu'un verrou 67 fixé au coffre et relié au moins au groupe de pivotement arrière 7 (moyen d'engagement 16) pour pouvoir le déverrouiller manuellement depuis l'extérieur du véhicule.

Dans le mode de réalisation représenté aux figures 2a, 2b, l'organe formant charnière 12 de chaque ensemble de pivotement 5, 7 comprend deux bras 40, 41 sensiblement parallèles, articulés (directement ou non) à une extrémité sur la partie interne du capot 4 et à l'extrémité opposée sur une patte (ou deuxième bras) 43 solidaire du premier élément d'assemblage 13 correspondant.

Avantageusement, lorsqu'une telle patte et au moins un tel bras 40 ou 41 existent, ceux-ci portent respectivement un deuxième et un troisième moyens 17, 21. Suivant le cas, le bras 41 pourvu de l'ergot 21 appuie ou non, en 44, sur une partie 45 de la patte 43. En particulier, des joints déformables 50, 52, prévus de préférence respectivement sur le pourtour intérieur du capot 4 et de la partie en regard de la carrosserie 10 (fig. 2a, 2b), peuvent être disposés et conçus, en liaison avec le système de verrouillage/articulation 5,7, de telle manière qu'une fois le verrou 16 (voire 160,260..) en prise avec le moyen complémentaire 17 (respectivement 170a,270a), les joints sont déjà dans leur état normalement comprimé et le jeu 19 (fig. 3) est déjà absorbé. Il n'est alors pas nécessaire que le verrou appuie sur le troisième moyen complémentaire 21 jusqu'à rattraper le jeu en 44 vis-à-vis du rebord 45: le bras 41 peut ne pas appuyer sur le rebord 45.

Les zones 44, 45 sont de préférence situées au-delà de l'ergot 17 (par rapport à la direction d'engagement 47 du moyen 16 repérée sur la figure 3), en position fermée du capot, pour que le verrouillage du capot favorisé par l'action de 16 sur 17 soit efficacement complété par l'effet élastique des joints et/ou l'appui en 44 qui sécurise le verrouillage et rattrape le jeu en 19 (plan de jonction de 13 et 14).

La zone à jeu contrôlé 44 est en outre située à une extrémité d'une excroissance 49 du bras dirigée vers un épaulement 45 de la patte 43 se présentant comme une excroissance plane. Les zones et moyens 21, 44, 45 sont, en position fermée du capot et suivant l'axe longitudinal 48 du véhicule, situés plus près de l'extrémité axiale la plus proche de ce capot que ne l'est l'organe 21 et la zone de coopération entre les éléments 13 et 14.

Dans les illustrations, où des doubles bras sont prévus, chaque patte 43 présente, sensiblement parallèlement à l'axe 48 et en position fermée du capot, un allongement, le bras 41, pourvu du troisième moyen d'engagement 21, s'articulant vers une extrémité axiale (4c ou 4d) du capot, l'autre bras 40 étant articulé vers l'extrémité 43a de la patte concernée la plus éloignée de l'extrémité axiale correspondante de ce capot, suivant l'axe 48.

Un ressort de rappel 51 prévu sur chaque ensemble de pivotement 5, 7 et placé entre le capot 4 et le corps 11 correspondant (ici la patte 43) rappelle par ailleurs le capot 4 dans sa position fermée des figures 2a et 2b.

On notera également qu'à l'avant, les crochets sont préférence ouverts vers l'avant et à l'arrière, ouverts vers l'arrière.

Bien que l'on puisse dissocier ce qui précède de ce qui suit, compte tenu des problèmes posés, on notera en outre sur avec intérêt la figure 3 la forme de la surface d'engagement 16c concave du crochet 16 située vers la partie extrême libre 16a1 de celui-ci (entre l'extrémité 16a et son coude 16d) et par laquelle le crochet engage les second et troisième moyens complémentaires d'engagement 17, 21. En effet, cette surface 16c s'étend avantageusement suivant un cercle C dont le centre est situé sur l'axe 16b de pivotement du crochet. Ainsi, comme montré sur cette figure, le crochet pourra assurer pendant toute sa course de pivotement une force d'appui sensiblement constante sur les moyens complémentaires d'engagement 21, et surtout 17 situé avant lui dans la course de verrouillage du crochet, une fois passé son biseau d'extrémité 16e qui permet, en liaison avec les surfaces de contact arrondies des éléments 17 et 21 (telles que la surface cylindrique 17a), d'amorcer progressivement le serrage et d'éviter des blocages.

Avec l'évolution suivant le cercle C de la surface 16c, on limite notablement les usures ou déformations de la tête 16a1 des crochets et/ou des éléments 17, 21, et donc les risques de jeu entre eux, néfaste au verrouillage.

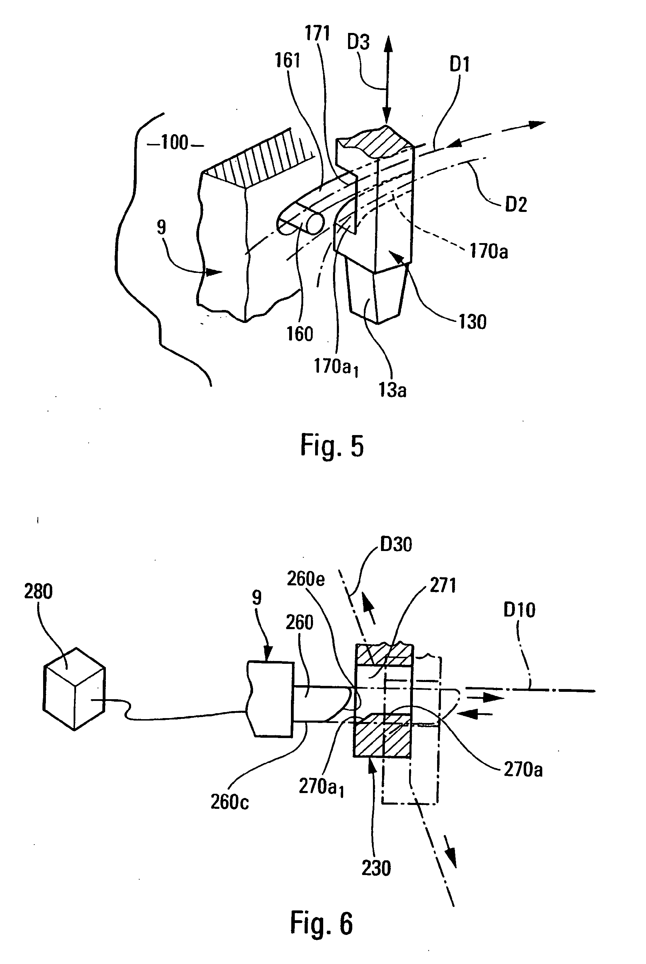

Sur la figure 5, le crochet est remplacé par un pion 160 à surface d'appui courbe 160c faisant saillie à travers une fente 161 d'une assise 9 liée au bâti (structure) 100 du véhicule. Le pion coulisse dans le fente pour coopérer avec une surface d'appui 170a courbe ménagée dans une lumière 171 du premier élément d'assemblage 130 (qui peut être identique par ailleurs au moyen 13, avec notamment le coin 13a).

Les directions D1, D2, respectivement de verrouillage et d'allongement du pion et de la surface 170a sont parallèles et ont la même courbure, seule l'amorce 170a1 de la surface 170a est plus pentue pour que le pion qui rencontre d'abord cette amorce, lors du pivotement final du capot, déplace l'élément 130 dans la direction d'engagement D3 (sensiblement perpendiculaire à D1), avant d'exercer la force d'appui constante recherchée, l'élément 130 ne bougeant plus suivant D3.

Sur la figure 6, l'élément mobile du verrou, lié à l'assise 9, est un pêne 260 à surface active 260c terminée par un chanfrein 260e et animé d'un mouvement de translation rectiligne suivant D10, transversalement à la direction d'engagement D30 s'étendant de biais. Lors du verrouillage, le pêne, mû par le moyen d'entraînement 280 (moteur électrique), rencontre d'abord, à l'intérieur de l'ouverture 271 où il peut s'engager, le biseau 270a1 de la surface 270a du premier élément d'assemblage 230 lié au capot. Le pêne pousse ainsi l'élément 230 vers le bas, suivant D30 (traits mixtes), jusqu'à ce qu'il atteigne la surface rectiligne 270a parallèle à la surface 260c.

Bien entendu, la présente invention n'est pas limitée aux modes de réalisation que l'on vient de décrire, et on peut apporter à ceux-ci des modifications sans sortir du domaine de l'invention.

On peut ainsi remplacer les formes en coin des éléments d'assemblage 13 et 14 par des formes tronconiques ou des formes en tronc de pyramide assurant un guidage à la fois dans un plan longitudinal et dans un plan transversal.

On pourrait également prévoir l'assise 9, le crochet 16 et son moteur sur le capot 4 et le corps 11 sur la carrosserie 10 du véhicule.

## Revendications

1. Véhicule découvrable (1) comprenant un coffre arrière (3), un capot (4) pour ce coffre arrière et un toit (2) repliable à l'intérieur du coffre (3), un groupe de pivotement avant (5) adapté à faire pivoter le capot (4) de l'arrière vers l'avant et un groupe de pivotement arrière (7) adapté à faire pivoter ledit capot (4) de l'avant vers l'arrière, chaque groupe de pivotement (5, 7) comprenant une assise (9) liée fixement à la carrosserie (10) du véhicule (1), un corps (11) qui est lié au capot (4) par un organe formant charnière (12) et qui comprend un premier élément d'assemblage (13) adapté à engager de manière amovible un second élément d'assemblage (14) lié à l'assise (9) correspondante, et des moyens de verrouillage comprenant un premier moyen d'engagement (16;160;260) lié à l'assise de façon mobile et adapté pour engager de manière libérable un second moyen complémentaire d'engagement (17,171,271) lié au premier élément d'assemblage pour, dans une position verrouillée, verrouiller le corps (11) par rapport à ladite assise (9), le premier élément d'assemblage (13,130,230) de chaque groupe de pivotement (5, 7) comprenant un troisième moyen complémentaire d'engagement (21) adapté pour être engagé de manière libérable par le premier moyen d'engagement (16,160,260), lequel est conçu pour pouvoir occuper plusieurs positions dont une position de rotation autorisée du capot dans laquelle, à l'endroit de l'un parmi les groupes de pivotement avant et arrière, ce premier moyen d'engagement maintient engagé avec lui le second moyen complémentaire d'engagement tout en libérant de son engagement le troisième moyen complémentaire d'engagement (21), assurant ainsi l'effet de charnière lors du pivotement d'ouverture du capot, **caractérisé en ce que** :
- à l'endroit de l'autre parmi lesdits groupes de pivotement avant et arrière (5, 7), le premier moyen d'engagement (16,160,260) concerné libère alors de leur engagement avec lui à la fois le second et le troisième moyens complémentaires d'engagement, pour que le capot puisse donc être écarté à cet endroit de la carrosserie (10, 100) en pivotant autour de ladite charnière (12) crée;
- tandis que, lors du verrouillage du corps (11) par rapport à l'assise (9), le premier moyen d'engagement (16) du groupe de pivotement concerné rencontre et appuie successivement sur les deuxième(s) puis troisième(s) moyens complémentaires d'engagement.

2. Véhicule selon la revendication 1, dans lequel l'organe formant charnière (12) de chaque groupe de pivotement (5, 7) comprend au moins un bras (40, 41) articulé d'un côté vis-à-vis du capot (4) et à d'un autre côté vis-à-vis du corps (11) correspondant, **caractérisé en ce que** le troisième moyen complémentaire d'engagement concerné (21) est situé sur ce bras ou l'un de ceux-ci.

3. Véhicule selon la revendication 2, **caractérisé en ce que** :
- le deuxième moyen complémentaire d'engagement consiste dans une conformation d'appui (17,170a,270a) solidaire d'une patte (43) du corps (11) sur laquelle le bras concerné (40, 41) est articulé à sa dite autre extrémité,
- le troisième élément complémentaire d'engagement consiste dans une conformation d'appui (21) solidaire dudit bras,
- et lorsque le premier moyen d'engagement correspondant (16) rencontre et appuie successivement sur ces deuxième puis troisième moyens complémentaires d'engagement lors du verrouillage du corps (11) par rapport à l'assise (9), le bras (41) pourvu dudit troisième moyen complémentaire d'engagement (21) appuie alors lui-même sur une partie de la patte (43), dans le sens de l'inter-engagement des premier et second éléments d'assemblage qui s'engagent donc l'un dans l'autre.

4. Véhicule selon la revendication 3, **caractérisé en ce que** la partie (45) de ladite patte (43) contre laquelle le bras (41) concerné appuie lors du verrouillage du corps est située au-delà du deuxième moyen complémentaire d'engagement (17) lorsque le premier moyen d'engagement (16) s'engage avec ces deuxième puis troisième moyens complémentaires d'engagement.

5. Véhicule selon la revendication 2, **caractérisé en ce que** l'organe formant charnière (12) de chaque groupe de pivotement (5, 7) comprend deux dits bras (40, 41) sensiblement parallèles et articulés chacun, à une extrémité, par rapport au capot (4) et, à l'autre extrémité, par rapport à une patte du corps (11) correspondant, chaque patte (43) présentant, sensiblement parallèlement à l'axe longitudinal (48) d'avance du véhicule et en position fermée du capot, un allongement, le bras (41) qui est pourvu du troisième moyen d'engagement (21) s'articulant vers une extrémité axiale (4c, 4d) du capot, l'autre bras (40) étant articulé vers l'extrémité (43a) de la patte concernée la plus éloignée de l'extrémité axiale correspondante de ce capot, suivant ledit axe longitudinal.

6. Véhicule selon la revendication 5, **caractérisé en ce que** :
- le deuxième moyen complémentaire d'engagement (17,171,271) consiste dans une conformation d'appui solidaire de la patte (43) sur laquelle le bras concerné est articulé à sa dite autre extrémité,
- le troisième moyen complémentaire d'engagement (21) consiste dans une conformation d'appui solidaire dudit bras (41),
- le premier moyen d'engagement correspondant (16,160,260) rencontre et appuie successivement sur ces deuxième puis troisième moyens complémentaires d'engagement lors du verrouillage du corps (11) par rapport à l'assise (9), le bras (41) pourvu dudit troisième moyen complémentaire d'engagement appuyant alors lui-même sur une partie de la patte (43) dans le sens (18) de la l'engagement des premier et second éléments d'assemblage l'un avec l'autre,
- et ladite partie (45) de cette patte est située, en position fermée du capot, plus près de l'extrémité axiale (4c, 4d) la plus proche de ce capot que ne l'est le deuxième moyen complémentaire d'engagement (17).

7. Véhicule selon l'une quelconque des revendications précédentes, **caractérisé en ce que** chaque premier moyen d'engagement comprend un crochet de verrouillage (16) monté pivotant vis-à-vis de l'assise correspondante (9), et le troisième moyen d'engagement (21) que le crochet engage lors du verrouillage du corps est situé au-delà du second moyen complémentaire d'engagement correspondant (17) lors du pivotement de verrouillage du crochet par rapport à l'assise.

8. Véhicule selon l'une quelconque des revendications 1 à 6, **caractérisé en ce que** le (s) premier(s) moyens d'engagement, d'une part, le(s) second(s) et troisième(s) moyen(s) complémentaires d'engagement, d'autre part (16,17;160,171;260,271), présentent respectivement des première, seconde et troisième surfaces de contact entre eux ayant des formes coopérantes liées au mouvement du premier moyen d'engagement (16,160,260) concerné sur son chemin de déplacement, pour que sur l'essentiel au moins de sa course, ledit premier moyen d'engagement exerce sur les deuxième et troisième moyens complémentaires d'engagement correspondants une force d'appui sensiblement constante.

9. Véhicule selon la revendication 8, **caractérisé en ce qu'**au moins la première surface de contact présente une zone d'appui initial (16e,17a;170a,260e,270a1) où s'amorce, lors d'un verrouillage, le contact entre les surfaces concernées, cette zone d'appui initial étant inclinée par rapport à la direction (C,D1,D10) de déplacement du premier moyen d'engagement (16,160,260) et interposée en travers du chemin de ce premier moyen d'engagement, pour que celui-ci déplace les deuxième et troisième moyens d'engagement (17,171,271) correspondants suivant ladite direction de verrouillage, en exerçant une force d'appui, qui croît à mesure que se poursuit le contact, avant que ladite force d'appui devienne et demeure sensiblement constante, tandis que les deuxième puis troisième moyens complémentaires d'engagement ne se déplacent alors sensiblement plus suivant ladite direction de verrouillage.

10. Véhicule selon la revendication 8 ou 9,
**caractérisé en ce que** le premier moyen d'engagement comprend un moyen à crochet (16) pivotant vis-à-vis de l'assise correspondante (9) et présentant une surface d'engagement (16c,160) le long de laquelle il engage le second puis le troisième moyens complémentaires d'engagement (17,170a) correspondants, cette surface d'engagement s'étendant suivant un cercle (C) dont le centre est situé sur l'axe (16b) de pivotement du premier moyen d'engagement.

11. véhicule selon l'une quelconque des revendications précédentes, **caractérisé en ce qu'**il comporte des moyens (63, 64a, 64b) de commande des premiers moyen d'engagement (16), de sorte que :
- pour un verrouillage en position fermée du capot, les premiers éléments d'engagement des groupes de pivotement (5, 7) engagent de façon coordonnée les seconds et troisièmes moyens complémentaires d'engagement correspondants (17, 21),
- pour une ouverture du capot pivotée vers l'arrière lors d'un repliement ou d'un déploiement du toit dans le, ou hors du, coffre, le (s) premier (s) moyen (s) d'engagement (16) des groupes de pivotement arrière et avant agissent pour respectivement engager uniquement le(s) second(s) moyens complémentaires d'engagement (17) du groupe de pivotement arrière (7) et libérer de façon coordonnée les second(s) et troisième(s) moyens complémentaires d'engagement du groupe de pivotement avant (5), et inversement pour une ouverture pivotée vers l'avant du capot, pour un accès à une zone de chargement de bagages dans le coffre.

## Claims

1. Convertible vehicle (1) comprising a rear boot (3), a hood (4) for this rear boot and a roof (2) foldable into the boot (3), a front pivoting set (5) capable of swivelling the hood (4) from the rear to the front and a rear pivoting set (7) capable of swivelling the hood (4) from the front to the rear, each pivoting set (5, 7) comprising a base (9) fixed to the bodyshell (10) of the vehicle (1), a body (11) which is linked to the hood (4) via a hinge member (12) and which comprises a first assembling element (13) capable of releasably engaging a second assembling element (14) linked to the corresponding base (9), and locking means comprising a first engaging means (16, 160, 260) removably linked to the base and capable of releasably engaging a second complementary engaging means (17, 171, 271) linked to the first assembling element so as to, in a locked position, lock the body (11) in relation to said base(9), the first assembling element (13, 130, 230) of each pivoting set (5, 7) comprising a third complementary engaging means (21) capable of being releasably engaged with the first engaging means (16, 160, 260), which is designed so as to be able to have several positions of which one authorised rotation position of the hood in which, at the place of one among the front and rear pivoting sets, this first engaging means maintains the second complementary engaging means engaged with it whilst releasing the third complementary engaging means (21) from its engagement, thus ensuring the hinge effect during the opening swivelling of the hood, **characterized in that**:
- at the place of the other among said front and rear pivoting sets (5, 7), the concerned first engaging means (16, 160, 260) releases both the second and third complementary engaging means from being engaged with it, so that the hood can then be moved at this place apart from the bodyshell (10, 100) by swivelling around said hinge (12),
- while during the locking of the body (11) in relation to the base (9) the first engaging means (16) of the concerned pivoting set successively meets and leans against the second then third complementary engaging means.

2. Vehicle set forth in claim 1, in which said hinge member (12) of each pivoting set (5, 7) comprises at least one arm (40, 41) articulated on one side in relation to the hood (4) and on the other side in relation to the corresponding body (11), **characterized in that** the concerned third complementary engaging element (21) is located on this arm or one of said arms.

3. Vehicle set forth in claim 2, **characterized in that**:
- the second complementary engaging means consists in a backup conformation (17, 170a, 270a) connected with a leg (43) of the body (11) on which leg the concerned arm (40, 41) is articulated on its said other end;
- the third complementary engaging element consists in a backup conformation (21) connected with said arm;
- and when the corresponding first engaging means (16) successively meets and leans against these second then third complementary engaging means during the locking of the body (11) in relation to the base (9), the arm (41) fitted with said third complementary engaging means (21) then itself leans against a part of the leg (43), in the direction of the inter-engagement of the first and second assembling elements which thereby engage into each other.

4. Vehicle set forth in claim 3, **characterized in that** the part (45) of said leg (43) against which the concerned arm (41) leans during the locking of the body is located beyond the second complementary engaging means (17) when the first engaging means (16) engages with these second then third complementary engaging means.

5. Vehicle set forth in claim 2, **characterized in that** the hinge member (12) of each pivoting set (5, 7) comprises two said arms (40, 41) substantially parallel and each articulated, at one end, in relation to the hood (4) and, on the other end, in relation to a leg of the corresponding body (11), each leg (43) having, substantially parallel to the longitudinal axis (48) of the vehicle travel direction and in the closed position of the hood, an elongation, the arm (41) which is fitted with the third engaging means (21) being articulated towards an axial end (4c, 4d) of the hood, the other arm (40) being articulated towards the end (43a) of the concerned leg the furthest from the corresponding axial end of this hood, along said longitudinal axis.

6. Vehicle set forth in claim 5, **characterized in that**:
- the second complementary engaging means (17, 171, 271) consists in a backup conformation connected with the leg (43) on which the concerned arm is articulated on its said other end;
- the third complementary engaging means (21) consists in a backup conformation connected with said arm (41);
- the first corresponding engaging means (16, 160, 260) successively meets and leans against these second then third complementary engaging means during the locking of the body (11) in relation to the base (9), the arm (41) fitted with said third complementary engaging means then itself leaning against a part of the leg (43), in the direction (18) of engagement of the first and second assembling elements with each other;
- and said part (45) of this leg is, in the closed position of the hood, located nearer the axial end (4c, 4d) which is the nearest to this hood than the second complementary engaging means (17).

7. Vehicle set forth in any one of the previous claims, **characterized in that** each first engaging means comprises a locking hook (16) pivotally mounted in relation to the corresponding base (9), and the third engaging means (21) which the hook engages during the locking of the body is located beyond the corresponding second complementary engaging means (17) during the locking swivelling of the hook in relation to the base.

8. Vehicle set forth in any one of claims 1 to 6, **characterized in that**, on one hand, the first engaging means, and on the other hand, the second and third complementary engaging means (16, 17; 160, 171; 260, 271), respectively have between them first, second and third contact surfaces with co-operative shapes linked to the movement of the first concerned engaging means (16, 160, 260) on its displacement track, so that for at least the main part of its stroke, said first engaging means applies a substantially constant back-up force on the corresponding second and third complementary engaging means.

9. Vehicle set forth in claim 8, **characterized in that** at least the first contact surface has an initial back-up zone (16e, 17a; 170a, 260e, 270a1) where, during a locking, the contact is initiated between the concerned surfaces, this initial back-up zone being tilted in relation to the displacement direction (C, D1, D10) of the first engaging means (16, 160, 260) and interposed across the track of the first engaging means, so that the latter displaces the corresponding second and third engaging means (17, 171, 271) according to said locking direction, by applying a back-up force that increases as the contact continues, before said back-up force becomes and remains substantially constant, whereas the second then third complementary engaging means are substantially no longer moving along said locking direction.

10. Vehicle set forth in claim 8 or 9, **characterized in that** the first engaging means comprises a hook means (16) pivoting in relation to the corresponding base (9) and having an engagement surface (16c, 160) along which it engages the corresponding second then third complementary engaging means (17, 170a), this engagement surface extending according to a circle (C) whose centre is located on the swivel axis (16b) of the first engaging means.

11. Vehicle set forth in any one of the previous claims, **characterized in that** it comprises means (63, 64a, 64b) of controlling the first engaging means (16), so that:
- for a locking in the closed position of the hood, the first engaging means of the pivoting sets (5, 7) engage, in a co-ordinated manner, the corresponding second and third complementary engaging means (17, 21);
- for an opening of the hood swivelled towards the rear during folding or unfolding the roof in, or out of, the boot, the first engaging means (16) of the rear and front pivoting sets operate so as to respectively solely engage the second complementary engaging means (17) of the rear pivoting set (7) and release, in a co-ordinated manner, the second and third complementary engaging means of the front pivoting set (5), and inversely for an opening of the hood swivelled towards the front, to access a luggage loading zone in the boot.

## Patentansprüche

1. Abdeckbares Fahrzeug (1) umfassend einen hinteren Kofferraum (3), einen Deckel (4) für den hinteren Kofferraum und ein in das Innere des Kofferraums (3) faltbares Dach (2), eine vordere Gruppe Schwenkeinrichtungen (5), die zum Schwenken des Deckels (4) von hinten nach vorne geeignet sind, und eine hintere Gruppe Schwenkeinrichtungen (7), die zum Schwenken des Deckels (4) von vorne nach hinten geeignet sind, wobei jede Gruppe Schwenkeinrichtungen (5, 7) eine Grundplatte (9) umfasst, die ortsfest an der Karosserie (10) des Fahrzeugs (1) befestigt ist, einen Körper (11) umfasst, der an dem Deckel (4) durch ein Scharnierteil (12) befestigt ist und der ein erstes Montageteil (13) umfasst, das mit einem zweiten Montageteil (14) in einem lösbaren Eingriff bringbar ist, das an der entsprechenden Grundplatte (9) befestigt ist, und Verriegelungsbauteile, die ein erstes Eingriffbauteil (16; 160; 260) umfassen, das beweglich mit der Grundplatte verbunden ist und zum freigebbaren Eingriff mit einem zweiten komplementären Eingriffbauteil (17, 171, 271) geeignet ist, welches mit dem ersten Eingriffbauteil verbunden ist, um in einer verriegelten Position den Körper (11) relativ zur Grundplatte (9) zu verriegeln, wobei das erste Montageteil (13, 130, 230) jeder Gruppe Schwenkeinrichtungen (5, 7) ein drittes komplementäres Eingriffsteil (21) umfasst, welches zum freigebbaren Eingriff mit dem ersten Eingriffbauteil (16, 160, 260) geeignet ist, welches erste Eingriffbauteil dazu konzipiert ist, mehrere Positionen einzunehmen, von denen eine Position für zugelassene Drehung des Deckels, in der an dem Ort einer der vorderen und hinteren Gruppen Schwenkeinrichtungen das erste Eingriffbauteil mit dem zweiten komplementären Eingriffbauteil in Eingriff bleibt, wobei das dritte komplementäre Eingriffbauteil (21) von dessen Eingriff ganz freigegeben ist, wodurch die Scharnierwirkung bei der Öffnungsschwenkbewegung des Deckels gewährleistet ist,
**dadurch gekennzeichnet, dass**
- am Ort der andere von der vorderer und hinterer Gruppen Schwenkeinrichtungen (5, 7) das erste betreffende Eingriffbauteil (16, 160, 260) deren Eingriff mit dem zweiten und dem dritten komplementären Eingriffbauteil gleichzeitig befreit, damit der Deckel beim Schwenken um das Scharnier (12) folglich an diesem Ort von der Karosserie (110, 100) ferngehalten werden kann,
- wobei bei dem Verriegeln des Körpers (11) im Bezug zur Grundplatte (9), das erste Eingriffbauteil (16) der betreffende Gruppe Schwenkeinrichtungen nacheinander auf das zweite (die zweiten) und dann das dritte (die dritten) komplementäre(n) Eingriffbauteil(e) trifft und sich daran abstützt.

2. Fahrzeug nach Anspruch 1, wobei das Scharnierteil (12) jeder Gruppe Schwenkeinrichtungen (5, 7) wenigstens einen Arm (40, 41) umfasst, der an einer Seite gegenüber dem Deckel (4) und an einer anderen Seite gegenüber dem entsprechenden Körper (11) gelenkig angebracht ist, **dadurch gekennzeichnet, dass** das dritte betreffende komplementäre Eingriffbauteil (21) auf dem Arm oder auf einem der Arme angeordnet ist.

3. Fahrzeug nach Anspruch 2, **dadurch gekennzeichnet, dass**
- das zweite komplementäre Eingriffbauteil eine mit einer Klaue (43) des Körpers (11) verbundene Stützanordnung (17, 171a, 271a) ist, auf der der betreffende Arm (40, 41) an dessen anderen Ende gelenkig angebracht ist,
- das dritte komplementäre Eingriffbauteil eine Stützanordnung (21) ist, die mit dem Arm verbunden ist,
- und, wenn das erste komplementäre Eingriffbauteil (16) bei der Verriegelung des Körpers (11) relativ zur Grundplatte (9) nacheinander auf die zweiten, dann dritten komplementären Eingriffbauteile auftrifft und sich daran abstützt, sich der mit dem dritten komplementären Eingriffbauteil (21) versehene Arm (41) dann selbst an einen Abschnitt der Klaue (43) abstützt, in Richtung des Eingriffs des ersten Montageteils mit dem zweiten Montageteils, die sich daher miteinander verbinden.

4. Fahrzeug nach Anspruch 3, **dadurch gekennzeichnet, dass** der Abschnitt (45) der Klaue (43), an den sich der betreffende Arm (41) bei der Verriegelung des Körpers abstützt, sich jenseits des zweiten komplementären Eingriffbauteils (17) befindet, wenn das erste Eingriffbauteil (16) mit dem zweiten, dann dritten komplementären Eingriffbauteil in Eingriff kommt.

5. Fahrzeug nach Anspruch 2, **dadurch gekennzeichnet, dass** das Scharnierteil (12) jeder Gruppe Schwenkeinrichtungen (5, 7) zwei Arme (40, 41) umfasst, die im Wesentlichen parallel zueinander angeordnet sind und jeweils an einem Ende bezogen auf den Deckel (4) und an einem anderen Ende bezogen auf eine Klaue des entsprechenden Körpers (11) gelenkig angebracht sind, wobei jede Klaue (43) im Wesentlichen parallel zur Längsachse (48) der Vorwärtsbewegung des Fahrzeugs und in geschlossener Position des Deckels eine Verlängerung umfasst, wobei der Arm (41), der mit dem dritten Eingriffbauteil (21) ausgestattet ist, sich nach einem axialen Ende (4c; 4d) des Deckels gelenkig verbindet ist, wobei der andere Arm (40) sich mit dem Ende (43a) der betroffenen Klaue gelenkig verbindet ist, das das entfernteste von der entsprechenden axialen Ende des Deckels der Längsachse folgend angeordnet ist.

6. Fahrzeug nach Anspruch 5, **dadurch gekennzeichnet, dass**:
- das zweite komplementäre Eingriffbauteil (17, 171, 271) eine mit der Klaue (43) verbundene Stützanordnung umfasst, auf welcher der betroffene Arm an seinem anderen Ende gelenkig angebracht ist,
- das dritte komplementäre Eingriffbauteil (21) eine Stützanordnung ist, die mit dem Arm (41) verbunden ist,
- das erste entsprechende Eingriffbauteil (16, 160, 260) bei der Verriegelung des Körpers (11) im Bezug zur Grundplatte (9) nacheinander auf die zweiten, dann dritten ergänzenden Eingriffbauteile trifft und sich daran abstützt, wobei der mit dem dritten ergänzenden Eingriffbauteil versehene Arm (41) sich dann selbst auf einen Abschnitt der Klaue (43) abstützt, in Richtung des Eingriffs des ersten Anschlussbauteils mit dem zweiten Anschlussbauteil,
- und der Abschnitt (45) der Klaue sich bei der geschlossenen Position des Deckels näher an dem am nächsten des Deckels liegenden axialen Ende (4c, 4d) befindet, als das zweite komplementäre Eingriffbauteil (17).

7. Fahrzeug nach einem der vorangehenden Ansprüche, **dadurch gekennzeichnet, dass** jedes erste Eingriffbauteil einen Verriegelungshaken (16) umfasst, der schwenkbar gegenüber der entsprechenden Auflagefläche (9) montiert ist, wobei das dritte Eingriffbauteil (21), das mit dem Haken während des Verriegelns des Baukörpers in Eingriff kommt, während des Schwenkens der Verriegelung des Hakens relativ zur Grundfläche jenseits des zweiten komplementären entsprechenden Eingriffbauteils (17) angeordnet ist.

8. Fahrzeug nach einem der vorangehenden Ansprüche 1 bis 6, **dadurch gekennzeichnet, dass** der (die) erste(n) Eingriffbauteil(e) einerseits und das (die) zweite(n) und dritte(n) komplementäre(n) Eingriffbauteil(e) (16, 17; 160, 171; 260, 271) andererseits jeweils erste, zweite und dritte miteinander Kontaktflächen aufweisen, die zusammenwirkende Formen aufweisen, die gemäß der Bewegung des ersten betreffenden Eingriffbauteils (16, 160, 260) auf seinem Verschiebeweg liegen, damit auf wenigstens dem hauptsächlichen Teil seines Weges das erste Eingriffbauteil auf das zweite und dritte ergänzende entsprechende Eingriffbauteil eine im Wesentlichen konstante Stützkraft ausübt.

9. Fahrzeug nach Anspruch 8, **dadurch gekennzeichnet, dass** wenigstens die erste Kontaktoberfläche einen initialen Stützbereich (16e, 17a;170a, 260a1) aufweist, auf den während einer Verriegelung den Kontakt zwischen den betreffenden Oberflächen hergestellt wird, wobei der initiale Stützbereich relativ zur Richtung (C, D1, D10) der Verlagerung des ersten Eingriffbauteils (16, 160, 260) rampenförmig ausgebildet ist und quer zu dem Weg des ersten Eingriffbauteils eingesetzt ist, damit es das zweite und dritte entsprechende Eingriffbauteil (17, 171, 271) verlagert, der Richtung der Verriegelung folgend, wobei es eine Stützkraft ausübt, welche mit der Dauer des Kontakts zunimmt, bevor die Stützkraft im Wesentlichen konstant wird und bleibt, wobei sich das zweite, dann dritte ergänzende Eingriffbauteil nun im Wesentlichen nicht weiter in die Richtung der Verriegelung verlagert.

10. Fahrzeug nach Anspruch 8 oder 9, **dadurch gekennzeichnet, dass** das erste Eingriffbauteil eine Hakeneinrichtung (16) umfasst, die relativ zur entsprechenden Grundplatte (9) schwenkbar angeordnet ist und eine Eingriffoberfläche (16c, 160) aufweist, entlang welcher die Hakeneinrichtung mit dem zweiten, dann dritten komplementären entsprechenden Eingriffbauteil (17, 170a) in Eingriff kommt, wobei die Eingriffoberfläche sich nachfolgend entlang eines Kreises (C) erstreckt, dessen Mittelpunkt auf der Schwenkachse (16b) des ersten Eingriffbauteils angeordnet ist.

11. Fahrzeug nach einem der vorangehenden Ansprüche, **dadurch gekennzeichnet, dass** es Bauteile (63, 64a, 64b) zum Betätigen der ersten Bauteile (16) umfasst, so dass:
- bei einer Verriegelung in einer geschlossenen Position des Deckels, die ersten Eingriffbauteile der Gruppen Schwenkeinrichtungen (5, 7) in einer aufeinander abgestimmten Art und Weise die zweiten und dritten ergänzenden entsprechenden Bauteile (17, 21) in Eingriff nehmen,
- um eine, bei einem Zurückziehen oder Ausfalten des Dachs in den oder aus dem Kofferraum, nach hinten geschwenkte Öffnung des Deckels das (die) erste(n) aufliegenden Bauteil(e) (16) der hinteren und vorderen Gruppen Schwenkeinrichtungen wirken, um jeweils das ausschließliche Eingreifen der (des) zweiten ergänzenden Eingriffbauteils(bauteile) (17) der hintere Gruppe Schwenkeinrichtungen (7) zu ermöglichen und in einer aufeinander abgestimmten Art und Weise die zweite(n) und dritte(n) ergänzenden Eingriffbauteile der vordere Gruppe Schwenkeinrichtungen (5) zu befreien, und umgekehrt für eine nach vorne geschwenkte Öffnung des Deckels nach vorne, für einen Zugang in einem Ladebereich der Taschen in dem Kofferraum.
